# FASCICULE DE BREVET EUROPEEN

(11) **EP 0 962 967 B1**
(45) Date de publication et mention de la délivrance du brevet: **14.03.2007**
(21) Numéro de dépôt: 99401338.1
(22) Date de dépôt: 03.06.1999
(51) Int. Cl.: H01L 21/331, H01L 29/737, H01L 29/08

(54) **Procédé de dopage sélectif du collecteur intrinsèque d'un transistor bipolaire vertical à base épitaxiée**
Verfahren zur selecktiven Dotierung von dem Kollektor eines vertikalen bipolaren Transistors mit epitaxialer Basis
Method for selectively doping the intrinsic collector of an epitaxial base vertical bipolar transistor

(30) Priorité: 05.06.1998 FR 9807060
(43) Date de publication de la demande: 08.12.1999
(73) Titulaire: STMicroelectronics S.A., 92120 Montrouge (FR); COMMISSARIAT A L'ENERGIE ATOMIQUE, 75015 Paris (FR); FRANCE TELECOM, 75015 Paris (FR)
(72) Inventeur: Marty, Michel, 38760 St. Paul de Varces (FR); Chantre, Alain, 38180 Seyssins (FR); Schwartzmann, Thierry, 38000 Grenoble (FR)
(74) Mandataire: Casalonga, Axel

(56) Documents cités:
- EP-A- 0 762 511
- EP-A- 0 795 899
- DE-A- 19 643 903
- US-A- 5 321 301
- US-A- 5 656 514
- REN Q W ET AL: "Silicon nitride as dielectric in the low temperature SiGe HBT processing" MICROELECTRONIC ENGINEERING, vol. 36, no. 1-4, juin 1997 (1997-06), page 179-182 XP004075254
- BURGHARTZ J N ET AL: "AN ULTRA-LOW THERMAL-BUDGET SIGE-BASE BIPOLAR TECHNOLOGY" DIGEST OF TECHNICAL PAPERS OF THE SYMPOSIUM ON VLSI TECHNOLOGY, KYOTO, MAY 17 - 19, 1993,17 mai 1993 (1993-05-17), page 59/60 XP000462905 INSTITUTE OF ELECTRICAL AND ELECTRONICS ENGINEERS

## Description

L'invention concerne les transistors bipolaires verticaux à base à hétérojonction silicium-germanium, notamment ceux destinés à s'intégrer dans les technologies haute fréquence et à très haut degré d'intégration (technologie VLSI : "Very Large Scale Integration" en langue anglaise), et en particulier le surdopage sélectif du collecteur intrinsèque d'un tel transistor à base épitaxiée à hétérojonction silicium-germanium (SiGe).

Un but de l'invention est d'augmenter la rapidité de tels transistors.

L'invention a également pour but de pouvoir optimiser la valeur de la résistance collecteur tout en évitant une augmentation trop importante de la capacité collecteur/base.

Dans une autre demande de brevet déposée par le demandeur le même jour que la présente publiée en tant que EP-A-0 962 966, ayant pour titre "transistor bipolaire vertical à faible bruit et procédé de fabrication correspondant", il a été décrit un procédé de réalisation d'un transistor bipolaire vertical à base à hétérojonction silicium-germanium et émetteur épitaxié sur la surface supérieure de cette base. Cette demande ne fait pas partie de l'état de la technique.

Au cours de la réalisation d'un tel transistor, on procède à un dopage sélectif du collecteur intrinsèque dans une région de ce collecteur intrinsèque située sous la fenêtre émetteur, et ce de façon à augmenter la rapidité du transistor, c'est-à-dire la valeur de sa fréquence de transition (fréquence de coupure du gain en courant) et la valeur de sa fréquence maximale d'oscillation (fréquence de coupure du gain en puissance).

Ce dopage sélectif s'effectue de préférence à partir de deux implantations successives de phosphore, à travers la base à hétérojonction qui a été précédemment épitaxiée sur la surface du collecteur intrinsèque. Pour ces implantations, on utilise le bloc de résine ayant servi à graver la fenêtre émetteur, de façon à obtenir une implantation de la zone surdopée du collecteur, alignée avec la fenêtre émetteur.

Or, le fait d'implanter à travers la base crée des défauts dans celle-ci, ce qui va provoquer une diffusion du bore de la base, et ce d'autant plus que la dose de dopant implantée dans le collecteur intrinsèque est importante. Il en résulte finalement un élargissement de la base conduisant à une diminution de la rapidité du transistor.

D'autre part, les défauts nés contribuent activement à relaxer la couche de SiGe, ce qui engendre des dislocations mettant ainsi en court-circuit les jonctions du transistor.

Le document de J.N. Burghartz et al, intitulé "An Ultra-Low Thermal-Budget SiGe-Base Bipolar Technology" publié le 17.05.1993 dans DIGEST OF TECHNICAL PAPERS OF THE SYMPOSIUM ON VLSI TECHNOLOGY. KYOTO, MAY 17 - 19, 1993, SYMPOSIUM ON VLSI TECHNOLOGY, NEW YORK, IEEE, US, Pages 59-60, INSTITUTE OF ELECTRICAL AND ELECTRONICS ENGINEERS XP0462905 décrit un procédé de fabrication d' un transistor bipolaire à hétéro jonction Si / SiGe. Une zone de collecteur intrinsèque est sélectivement implantée à travers la base épitaxiée.

Le document EP-A- 0 762 511 décrit l'utilisation de plusieurs implantations sélectives de collecteur, la plus profonde étant plus fortement dopée.

L'invention propose donc, selon un mode de mise en oeuvre, un procédé de dopage sélectif du collecteur intrinsèque d'un transistor bipolaire vertical à base à hétérojonction silicium-germanium, comprenant une étape de réalisation du collecteur intrinsèque (par exemple par épitaxie ou implantation) sur une couche de collecteur extrinsèque enterrée dans un substrat semiconducteur, une étape de réalisation d'une région d'isolement latéral entourant la partie supérieure du collecteur intrinsèque et d'un puits de collecteur extrinsèque déporté contactant la couche de collecteur extrinsèque enterrée, une étape de réalisation d'une base à hétérojonction silicium-germanium située au-dessus du collecteur intrinsèque et de la région d'isolement latéral et comportant une épitaxie non sélective d'un empilement de couches de silicium et de silicium-germanium (par exemple un empilement d'une couche de SiGe encapsulée par deux couches de silicium), une première implantation de dopants dans le collecteur intrinsèque effectuée avant ladite épitaxie non sélective, par une première fenêtre d'implantation ménagée au-dessus du collecteur intrinsèque, et une deuxième implantation de dopants dans le collecteur intrinsèque, de plus faible dose d'implantation et de plus faible énergie que la première implantation, à travers l'empilement épitaxié, dans une deuxième fenêtre d'implantation située à l'intérieur de la première fenêtre, ménagée au-dessus dudit empilement, et autoalignée avec l'émetteur.

Cet autoalignement de la deuxième implantation avec l'émetteur est notamment réalisé en utilisant comme masque d'implantation pour la deuxième implantation, le masque de définition de la fenêtre émetteur Ladite deuxième fenêtre d'implantation est alors de même taille que la fenêtre émetteur.

En d'autres termes, selon une caractéristique générale de ce mode de mise en oeuvre de l'invention, on réalise une première implantation de dopants dans le collecteur intrinsèque avant la formation de l'empilement au sein duquel est réalisée la base intrinsèque, cette implantation étant de forte énergie. On réalise ensuite une deuxième implantation de dopants dans le collecteur intrinsèque à travers la base épitaxiée, cette deuxième implantation étant de plus faible dose d'implantation que la dose d'implantation de la première, typiquement dans un facteur 10. Il en résulte donc une quantité de défauts beaucoup moins importante dans l'empilement ce qui conduit à l'obtention d'une base intrinsèque plus mince et par conséquent à une augmentation de la rapidité du transistor.

Par ailleurs, le fait de réaliser deux implantations distinctes de dopants dans le collecteur intrinsèque permet de pouvoir moduler la largeur de la première fenêtre d'implantation, indépendemment de la largeur de la deuxième fenêtre d'implantation.

Ainsi, alors que les deux fenêtres d'implantation pourraient être choisies de même taille, il est particulièrement avantageux de choisir une première fenêtre d'implantation plus large que la deuxième de façon à pouvoir élargir la première zone surdopée implantée dans le collecteur et à pouvoir ainsi diminuer la résistance collecteur. Dans le cas où l'on élargit cette première fenêtre d'implantation, l'homme du métier pourra alors aisément moduler la dose d'implantation et l'énergie d'implantation de cette première implantation de façon à éviter une remontée trop importante de dopant dans le silicium et par conséquent éviter une augmentation trop importante de la capacité collecteur-base.

Selon un mode de mise en oeuvre du procédé selon l'invention, dans lequel l'étape de réalisation de la base comporte, avant l'épitaxie dudit empilement, l'ouverture, dans une couche de protection, par exemple du silicium amorphe, s'étendant sur la région d'isolement latéral, d'une fenêtre de base au-dessus du collecteur intrinsèque, on utilise pour la première implantation de dopants dans le collecteur intrinsèque, un masque spécifique d'implantation dont la première fenêtre d'implantation est plus large que la deuxième fenêtre d'implantation mais moins large que la fenêtre de base.

En variante, on peut utiliser pour la première implantation de dopants, le masque de gravure de ladite fenêtre de base, ladite première fenêtre d'implantation étant alors identique à la fenêtre de base. Ceci permet d'économiser un masque et d'obtenir une zone inférieure surdopée du collecteur s'étendant sur toute la largeur de la zone active ce qui conduit à une diminution encore plus importante de la résistance collecteur.

D'autres avantages et caractéristiques de l'invention apparaîtront à l'examen de la description détaillée d'un mode de mise en oeuvre nullement limitatif et des dessins annexés sur lesquels :
- les figures 1 à 7 illustrent un premier mode de mise en oeuvre du procédé selon l'invention permettant l'obtention d'une zone surdopée de collecteur intrinsèque plus large dans sa partie inférieure que dans sa partie supérieure,
- la figure 8 illustre une comparaison entre un profil de dopage d'un transistor obtenu selon l'invention et un profil de dopage d'un transistor dans lequel on a effectué un dopage sélectif du collecteur intrinsèque entièrement à travers la base épitaxiée, et,
- la figure 9 illustre une autre variante d'une étape d'un procédé selon l'invention permettant l'obtention d'une zone surdopée inférieure de collecteur intrinsèque ayant toute la largeur de la zone active.

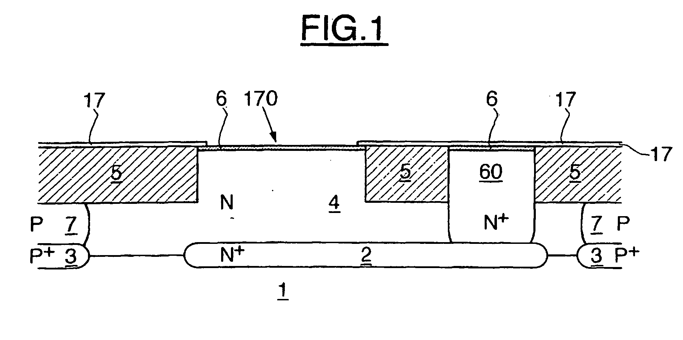

Sur la figure 1, la référence 1 désigne un substrat de silicium, par exemple du type P à la surface duquel on réalise de façon classique et connue en soi une couche enterrée 2 de collecteur extrinsèque, dopée N⁺, par une implantation d'arsenic.

On réalise de même, de façon classique, de part et d'autre du collecteur extrinsèque 2, deux couches enterrées 3, dopées P⁺ à partir d'une implantation de bore.

Sur le substrat 1 ainsi formé, on réalise une épitaxie épaisse, connue en soi, de façon à réaliser une couche 4 de silicium monocristalline de type N ayant une épaisseur typiquement de l'ordre de 1 micron.

On réalise ensuite dans cette couche 4, de façon connue en soi, une région d'isolement latéral 5, soit par un procédé d'oxydation localisée (ou LOCOS), soit du type "tranchée peu profonde" ("Shallow Trench"). On a représenté sur la figure 1, à des fins de simplification, une région d'isolement latéral 5 du type à tranchée peu profonde.

On réalise également de façon classique, notamment par implantation de phosphore, un puits collecteur 60 dopé N⁺ contactant la couche enterrée 2.

On réalise ensuite des implantations de bore de façon à réaliser sous la région d'isolement latéral 5 des caissons 7 dopés P permettant un isolement vis-à-vis des transistors adjacents au transistor bipolaire décrit ici.

On fait croître ensuite, de façon classique, sur la surface du collecteur intrinsèque monocristallin épitaxié 4, un oxyde thermique, typiquement du dioxyde de silicium. Cette croissance de dioxyde de silicium se produit également sur toute la plaquette, et notamment sur le puits collecteur 60. Cet oxyde forme également l'oxyde de grille pour des transistors complémentaires à effet de champ à grilles isolées (transistors CMOS) réalisés conjointement au transistor bipolaire sur la même plaquette (technologie BiCMOS : Bipolaire CMOS).

On dépose ensuite sur le bloc semiconducteur ainsi formé une couche 17, formée de silicium amorphe ayant une épaisseur de l'ordre de 50 nm (500 Å).

On grave ensuite, par gravure plasma avec arrêt sur la couche d'oxyde 6, une fenêtre 170 dite "fenêtre de base" en utilisant un masque et un bloc de résine non représenté sur cette figure 1. Dans le cas où un isolement latéral du type tranchée peu profonde est utilisé, les deux parties de la couche 17 de silicium gravée débordent légèrement au-dessus du collecteur intrinsèque 4. Dans le cas où un isolement latéral du type LOCOS est utilisé, la fenêtre 170 de gravure peut être plus large que le collecteur intrinsèque 4.

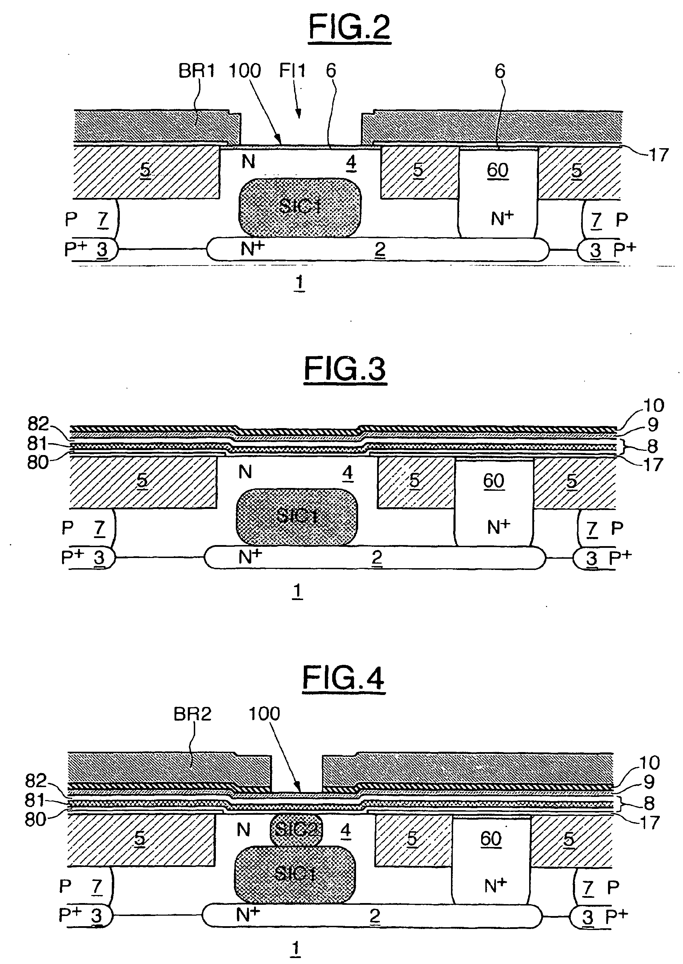

On réalise sur le bloc semiconducteur de la figure 1, à l'aide d'un masque, un bloc de résine BR1 comportant une cavité au-dessus du collecteur intrinsèque et correspondant à une première fenêtre d'implantation FI1 (figure 2).

On procède alors à une première implantation de dopants (phosphore) dans le collecteur intrinsèque à travers l'oxyde 6, de façon à réaliser une première zone surdopée SIC1 dans le collecteur. La dose d'implantation de cette première implantation est par exemple de l'ordre ou supérieure à 10¹³ at/cm² et l'énergie est de l'ordre de 200 à 300 Kev.

On procède ensuite (figure 3) à une désoxydation chimique de la couche d'oxyde 6 située au-dessus du collecteur. Il convient de noter ici que l'une des fonctions de la couche de silicium amorphe 17 est une fonction de protection du reste de la plaquette lors de cette désoxydation chimique et notamment des zones d'isolement latéral lorsque celles-ci sont réalisées par des tranchées peu profondes.

On procède ensuite, après un traitement de désorption de la fenêtre de base sous hydrogène à une température supérieure à 600°C, à une épitaxie d'un empilement 8 de trois couches 80, 81 et 82, au sein desquelles sera réalisée la future base du transistor. Plus précisément, on procède à une épitaxie d'une première couche 80 de silicium non dopée sur une épaisseur de quelques dizaines de nanomètres. La deuxième couche 81 formée de silicium-germanium est ensuite épitaxiée. Elle est en fait composée d'une première sous-couche de Siₗ₋ₓGeₓ avec x constant compris entre 0,1 et 0,2 surmontée d'une deuxième sous-couche formée également d'un alliage de Siₗ₋ₓGeₓ (avec x par exemple décroissant jusqu'à 0) et dopée P par du bore. L'épaisseur totale de la couche 81 est peu importante, typiquement de 20 à 100 nm.

La deuxième sous-couche de la couche 81 est ensuite surmontée d'une couche épitaxiée 82 de quelques dizaines de nanomètres d'épaisseur de silicium dopé P à partir de bore.

A l'issue de cette épitaxie, réalisée typiquement à 700°C dans un réacteur de dépôt CVD ultrapropre, on obtient donc un empilement de couches monocristallines sur le collecteur intrinsèque dans la fenêtre de base, et polycristallines au-dessus des couches de silicium amorphe 17. Cet empilement de couches va permettre de former une base à hétérojonction silicium-germanium. Il est à noter ici que l'épitaxie de réalisation de la base à hétérojonction est une épitaxie non sélective.

Par ailleurs, la présence de la couche de silicium amorphe 17 permet de présenter en début d'épitaxie une surface essentiellement formée de silicium ce qui permet d'obtenir une vitesse de croissance sensiblement identique sur le collecteur intrinsèque et sur le silicium amorphe conduisant à l'obtention d'une meilleure homogénéité en épaisseur de la base.

On dépose ensuite sur la couche 81 une première couche de dioxyde de silicium ayant une épaisseur de l'ordre de 20 nm (200Å). On dépose également sur la première couche de dioxyde de silicium 9, une deuxième couche 10 de nitrure de silicium (Si₃N₄) ayant une épaisseur de 300 Å.

On définit ensuite (figure 4) à l'aide d'un masque une zone 100 dans la couche de nitrure 10 correspondant à une fenêtre émetteur située au-dessus du collecteur intrinsèque 4. On effectue alors de façon classique, à l'aide d'une couche de résine BR2 correspondant audit masque, une gravure plasma de la couche de nitrure 10 avec arrêt sur la couche de dioxyde de silicium 9 de façon à dégager la zone 100. On procède ensuite, en conservant la résine présente sur la couche 10 et ayant servi à la gravure de cette dernière, à une deuxième implantation de phosphore, à travers l'empilement 8, (par exemple de l'ordre de 10¹² atomes/cm² avec une énergie de l'ordre ou supérieure à 100 Kev) de façon à réaliser une deuxième zone surdopée SIC2 dans le collecteur intrinsèque.

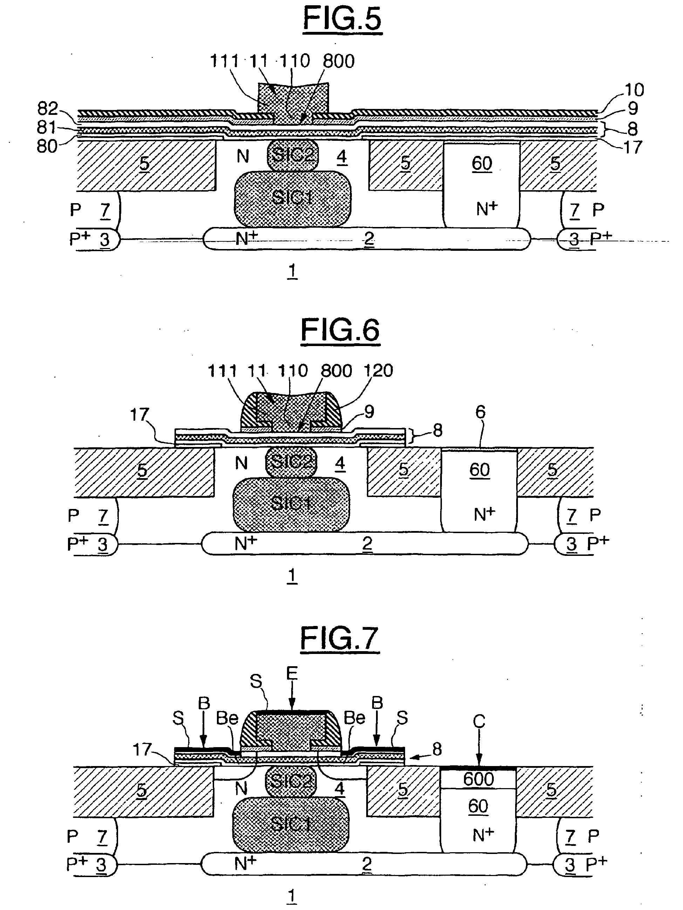

A l'issue de cette étape, on retire la résine présente sur la couche de nitrure de silicium 10 et l'on procède à un traitement chimique de desoxydation de façon à retirer la partie de la couche de dioxyde de silicium 9 située dans la zone 100 et réaliser ainsi la fenêtre émetteur 800 (figure 5).

La deuxième fenêtre d'implantation 100 utilisée pour la deuxième implantation de dopants est donc identique à la fenêtre émetteur, ce qui garantit un autoalignement de la zone SIC2 par rapport à la fenêtre émetteur et donc par rapport à l'émetteur.

Un exemple d'un traitement chimique de désoxydation consiste à utiliser un bain d'acide à base d'acide fluorhydrique dilué à environ 1% pendant 1 minute, ce qui permet d'obtenir une surface de silicium monocristallin chimiquement propre, c'est-à-dire dont la concentration d'atomes d'oxygène est inférieure à 10¹⁵/cm². Par ailleurs, une telle désoxydation chimique ne dégrade pas la surface de silicium monocristallin sous-jacente (au contraire d'une gravure plasma par exemple) et par conséquent n'introduit pas de défauts cristallins.

Pour parfaire encore l'état de surface du silicium, on effectue avantageusement un traitement de désorption sous hydrogène à haute température (> à 550°C) de façon à évacuer des impuretés résiduelles adsorbées à la surface du silicium lors de la désoxydation.

On procède ensuite dans un réacteur de dépôt CVD ultrapropre, par exemple celui commercialisé par la Société Applied Materials sous la référence CENTURA HTF à la réalisation de l'émetteur du transistor.

Plus précisément, on expose le bloc semiconducteur avec la base découverte au niveau de la fenêtre émetteur 800 à un mélange gazeux de silane et d'arsine, dans une atmosphère non oxydante, typiquement sous vide, ou sous hydrogène.

Les conditions du dépôt CVD sont par exemple un débit de 10 litres d'hydrogène/mn, un débit de 0,5 litres de silane/mn et un débit de 0,12 cm³ d'arsine/mn, à 630°C et sous une pression de 80 Torr.

L'homme du métier aura remarqué que ces conditions correspondent en fait à un dépôt polysilicium. Cependant, en raison du caractère chimiquement propre de la surface monocristalline de la base découverte au niveau de la fenêtre 800, le silicium déposé dans ce réacteur, épitaxie, c'est-à-dire qu'il croît monocristallin sur la base.

Après avoir obtenu une couche de silicium ayant une épaisseur de l'ordre de 250 nm (2500 Å), on procède, de façon classique en utilisant un nouveau masque de photolithographie ainsi qu'un bloc correspondant de résine, à une gravure de la couche de silicium de façon à obtenir (figure 5) un émetteur 11 comportant dans la fenêtre 800 une partie inférieure 110 surmontée d'une partie supérieure 111 plus large que la fenêtre émetteur, la distance entre le bord de la fenêtre émetteur et le bord de la région 111 étant typiquement de l'ordre de 0,2 µ. Cet émetteur a donc été dopé in situ et il est monocristallin au moins au voisinage de l'interface avec la base dans la fenêtre émetteur.

On procède ensuite à un dépôt d'une couche de nitrure de silicium que l'on grave de façon à obtenir des espaceurs 120 incluant la couche 10 de Si₃N₄, s'appuyant sur les parois verticales de la région supérieure 111 de l'émetteur et sur la couche de dioxyde de silicium 9.

On définit ensuite à l'aide d'un nouveau masque, la géométrie de la base du transistor et l'on procède, après avoir préalablement gravé la couche d'oxyde 9, à une gravure de l'empilement des couches 17 et 8, de façon à obtenir la configuration illustrée sur la figure 6.

On dépose ensuite de part et d'autre de la base un bloc de résine, ainsi qu'une vignette de résine au-dessus de l'émetteur, puis on procède à une implantation P⁺ de l'empilement 8 à l'aide de bore, de façon à définir la base extrinsèque Be (figure 7). On procède ensuite, après avoir protégé le transistor par de la résine, à une implantation d'arsenic de façon à réaliser à la surface du puits collecteur une zone implantée N⁺ référencée 600.

L'étape finale consiste à réaliser les métallisations S de base d'émetteur et de collecteur par une technique connue du type "siliciure autoaligné" ("self aligned silicide") qui comporte le dépôt d'une couche de métal (par exemple du titane) pour former un siliciure (TiSi₂) sur les zones de silicium de la base extrinsèque, de l'émetteur et du collecteur extrinsèque.

Le transistor selon l'invention, tel qu'illustré sur la figure 7, est donc un transistor bipolaire vertical n-p-n à base à hétérojonction silicium-germanium amincie utilisable dans une technologie BiCMOS du type VLSI.

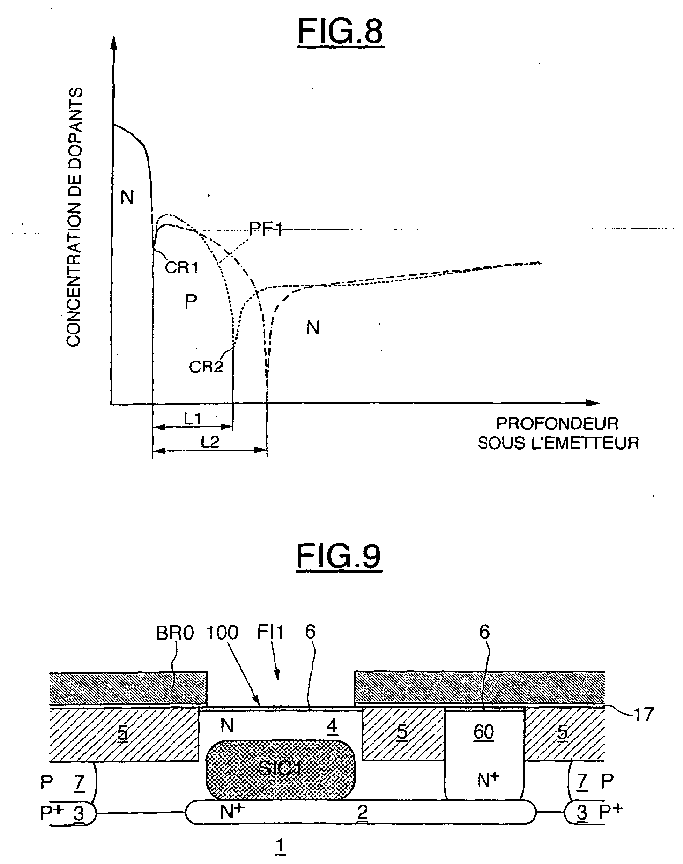

Un exemple de profil de dopage du transistor est illustré sur la figure 8 en pointillés. Ce profil PF1 présente un premier creux CR1 au niveau de la jonction émetteur-base qui se situe dans la partie basse de la couche 82. Ce profil comporte également un deuxième creux CR2 au niveau de la jonction base-collecteur qui se situe dans la partie basse de la sous-couche inférieure (Siₗ₋ₓGeₓ avec x = 0,12) de la couche 81. La distance L1 entre les creux CR1 et CR2 représente la largeur de la base intrinsèque.

L'homme du métier remarque que cette largeur L1 est plus petite que la largeur L2 de la base obtenue par un profil de dopage de forme analogue, représenté en tiretés, et correspondant à deux implantations de dopants effectuées toutes les deux à travers l'empilement épitaxié 80-82.

Par ailleurs, le niveau de dopage de la base est plus important avec le procédé selon l'invention.

En outre, dans le cas où la zone SIC2 est plus large que la zone SIC1, la résistance collecteur est réduite.

Outre ces caractéristiques, le transistor illustré sur la figure 7, comporte un émetteur monocristallin en contact avec le silicium de la base. Il en résulte un bruit basse fréquence réduit, avec de bons paramètres statiques, notamment le gain en courant, et ce grâce à la présence de l'héterojonction SiGe qui compense la disparition de l'oxyde d'interface présent dans les émetteurs polysilicium. Enfin, la résistance d'émetteur est réduite par rapport à un transistor à émetteur polycristallin (polysilicium).

Il est également particulièrement avantageux lors de la réalisation de l'émetteur dopé in situ de moduler la quantité de gaz dopant au fur et à mesure de l'épitaxie de l'émetteur. Ainsi, au début de l'épitaxie, on gardera par exemple le débit d'arsine mentionné ci-avant (0,12cm³/mn) tandis que dans la région supérieure de l'émetteur, on diminuera ce débit pour atteindre par exemple la valeur de 0,6 cm³/min. On obtiendra donc finalement, pour l'émetteur dopé in situ, une concentration de dopant As par exemple égale à 3 10²⁰/cm³ dans la région inférieure de l'émetteur au contact de la base et une concentration de dopant As par exemple égale à 10²⁰/cm³ dans la région supérieure de l'émetteur. Ces valeurs permettent d'obtenir donc à la fois une bonne injection d'électrons dans la partie inférieure de l'émetteur et une bonne siliciuration au-dessus de la partie supérieure de l'émetteur.

Ceci étant, l'invention n'est pas limitée à un transistor bipolaire vertical ayant un émetteur épitaxié. Elle s'applique de façon générale à tout type de transistor bipolaire vertical et en particulier également à ceux possédant un émetteur polycristallin (polysilicium), dans lesquels l'émetteur résulte d'un dépôt de polysilicium qui peut être réalisé dopé in situ dans un réacteur de dépôts chimiques en phase vapeur et comportant une couche d'oxyde présente à l'interface émetteur-base (émetteur-empilement 8).

En outre, on pourrait également remplacer la couche 17 de silicium amorphe par une couche de nitrure de silicium (Si₃N₄) ce qui conférerait une rugosité moins importante sur la surface de la base extrinsèque.

Enfin, l'invention peut s'appliquer à tout type de base épitaxiée, en particulier une base entièrement silicium dont l'empilement 8 se résumerait alors à une seule couche de silicium.

## Revendications

1. Procédé de dopage sélectif du collecteur intrinsèque d'un transistor bipolaire vertical, comprenant une étape de réalisation du collecteur intrinsèque (4) sur une couche de collecteur extrinsèque enterrée dans un substrat semiconducteur, une étape de réalisation d'une région d'isolement latéral (5) entourant la partie supérieure du collecteur intrinsèque et d'un puits de collecteur extrinsèque déporté contactant la couche de collecteur extrinsèque enterrée, une étape de réalisation d'une base située au dessus du collecteur intrinsèque (4) et de la région d'isolement latéral (5) comportant une épitaxie non sélective de ladite base (8), une première implantation de dopants dans le collecteur intrinsèque effectuée avant ladite épitaxie non sélective, par une première fenêtre d'implantation (FI1) ménagée au-dessus du collecteur intrinsèque, et une deuxième implantation de dopants dans le collecteur intrinsèque de plus faible énergie et de plus faible dose d'implantation, à travers la base épitaxiée, dans une deuxième fenêtre d'implantation (800) située à l'intérieur de la première fenêtre (FI1), ménagée au dessus de ladite base (8) et autoalignée avec l'émetteur.

2. Procédé selon la revendication 1, **caractérisé par le fait qu'**après la phase d'épitaxie de la base (8), on utilise un masque spécifique pour la définition d'une fenêtre émetteur (800) de l'émetteur, et **par le fait qu'**on utilise comme masque d'implantation pour la deuxième implantation le masque de définition de la fenêtre émetteur, ladite deuxième fenêtre d'implantation étant alors de même taille que la fenêtre émetteur.

3. Procédé selon la revendication 2, **caractérisé par le fait que** l'étape de réalisation de la base comporte, avant l'épitaxie dudit l'ouverture, dans une couche de protection s'étendant sur la région d'isolement latéral, d'une fenêtre de base (170) au-dessus du collecteur intrinsèque, et **par le fait qu'**on utilise pour la première implantation de dopants un masque spécifique d'implantation dont la première fenêtre d'implantation (FI1) est plus large que la deuxième fenêtre d'implantation (800) et moins large que la fenêtre de base (170).

4. Procédé selon la revendication 2, **caractérisé par le fait que** l'étape de réalisation de la base comporte, avant l'épitaxie de la base (8), l'ouverture, dans une couche de protection s'étendant sur la région d'isolement latéral, d'une fenêtre de base (170) au-dessus du collecteur intrinsèque, et **par le fait qu'**on utilise pour la première implantation de dopants le masque de gravure de ladite fenêtre de base (170), ladite première fenêtre d'implantation étant alors identique à la fenêtre de base.

5. Procédé selon l'une des revendications précédentes, dans lequel la base est une base à hétérojonction SiGe, et l'étape de réalisation de la base comporte une épitaxie non sélective d'un empilement (8) de couches de silicium et de SiGe.

## Claims

1. Method of selectively doping the intrinsic collector of a vertical bipolar transistor, comprising a step of producing the intrinsic collector (4) on an extrinsic collector layer buried in a semiconductor substrate, a step of producing a side insulation region (5) surrounding the upper part of the intrinsic collector and an offset extrinsic collector well contacting the buried extrinsic collector layer, a step of producing a base lying above the intrinsic collector (4) and the side insulation region (5) including nonselective epitaxy of the said base (8), first implantation of dopants in the intrinsic collector, carried out before the said nonselective epitaxy through a first implantation window (FI1) formed above the intrinsic collector, and second implantation of dopants in the intrinsic collector with a lower energy and lower implantation dose, through the epitaxially grown base, in a second implantation window (800) lying inside the first window (FI1), formed above the said base (8) and self-aligned with the emitter.

2. Method according to Claim 1, **characterized in that** after the phase of epitaxially growing the base (8), a specific mask is used for defining an emitter window (800) of the emitter, and **in that** the definition mask of the emitter window is used as the implantation mask for the second implantation, the said second implantation window then being of the same size as the emitter window.

3. Method according to Claim 2, **characterized in that** the step of producing the base includes, before the epitaxy of the base, opening a base window (170) over the intrinsic collector in a protection layer extending over the side insulation region, and **in that** a specific implantation mask, whose first implantation window (FI1) is wider than the second implantation window (800) and less wide than the base window (170) is used for the first implantation of dopants.

4. Method according to Claim 2, **characterized in that** the step of producing the base includes, before the epitaxy of the base (8), opening a base window (170) over the intrinsic collector in a protection layer extending over the side insulation region, and **in that** the mask for etching the said base window (170) is used for the first implantation of dopants, the said first implantation window then being identical to the base window.

5. Method according to one of the preceding claims, in which the base is an SiGe heterojunction base, and the step of producing the base includes nonselective epitaxy of a stack (8) of layers of silicon and SiGe.

## Patentansprüche

1. Verfahren zur selektiven Dotierung des intrinsischen Kollektors eines vertikalen bipolaren Transistors mit
einem Schritt zur Herstellung des intrinsischen Kollektors (4) auf einer in einem Halbleitersubstrat vergrabenen extrinsischen Kollektorschicht,
einem Schritt zur Herstellung eines seitlichen Isoliergebiets (5), das den oberen Teil des intrinsischen Kollektors und eines seitlich versetzt angeordneten extrinsischen Kollektorschachts umgibt, der die vergrabene extrinsische Kollektorschicht kontaktiert,
einem Schritt zur Herstellung einer oberhalb des intrinsischen Kollektors (4) und des seitlichen Isoliergebiets (5) angeordneten Basis, aufweisend eine nicht selektive Epitaxie der Basis (8),
einer vor der nicht selektiven Epitaxie durchgeführten ersten Implantation von Dotierstoffen in den intrinsischen Kollektor durch ein oberhalb des intrinsischen Kollektors ausgespartes erstes Implantationsfenster (FI1) und
einer zweiten Implantation von Dotierstoffen in den intrinsischen Kollektor mit geringerer Energie und geringerer Implantationsdosis über die Epitaxiebasis in einem zweiten Implantationsfenster (800), das innerhalb des ersten Fensters (FI1) angeordnet ist, oberhalb der Basis (8) ausgespart ist und mit dem Emitter ausgerichtet ist.

2. Verfahren nach Anspruch 1, **dadurch gekennzeichnet, daß** nach der Epitaxiephase der Basis (8) eine spezielle Maske verwendet wird, um ein Emitterfenster (800) des Emitters zu definieren, und **dadurch**, daß als Implantationsmaske für die zweite Implantation die Definitionsmaske des Emitterfensters verwendet wird, wobei das zweite Implantationsfenster somit die gleiche Größe hat wie das Emitterfenster.

3. Verfahren nach Anspruch 2, **dadurch gekennzeichnet, daß** der Schritt zur Herstellung der Basis vor der Epitaxie der Basis das Öffnen eines Basisfensters (170) oberhalb des intrinsischen Kollektors in einer Schutzschicht aufweist, die sich auf dem seitlichen Isoliergebiet erstreckt, und **dadurch**, daß für die erste Implantation von Dotierstoffen eine spezielle Implantationsmaske verwendet wird, deren erstes Implantationsfenster (FI1) breiter als das zweite Implantationsfenster (800) und weniger breit als das Basisfenster (170) ist.

4. Verfahren nach Anspruch 2, **dadurch gekennzeichnet, daß** der Schritt zur Herstellung der Basis vor der Epitaxie der Basis (8) das Öffnen eines Basisfensters (170) oberhalb des intrinsischen Kollektors in einer Schutzschicht aufweist, die sich auf dem seitlichen Isoliergebiet erstreckt, und **dadurch**, daß für die erste Implantation von Dotierstoffen die Ätzmaske des Basisfensters (170) verwendet wird, wobei das erste Implantationsfenster somit mit dem Basisfenster identisch ist.

5. Verfahren nach einem der vorstehenden Ansprüche, wobei die Basis eine SiGe-Heterojunction-Basis ist und der Schritt zur Herstellung der Basis eine nicht selektive Epitaxie eines Stapels (8) von Silizium- und SiGe-Schichten aufweist.
